# EUROPÄISCHE PATENTSCHRIFT

(11) **EP 0 900 363 B1**
(45) Veröffentlichungstag und Bekanntmachung des Hinweises auf die Patenterteilung: **10.04.2002**
(21) Anmeldenummer: 97923987.8
(22) Anmeldetag: 22.05.1997
(51) Int. Cl.: G01D 5/14, G01D 5/16, H03K 17/95, B65H 51/22

(54) **VERFAHREN ZUM STEUERN EINES DIGITALEN SENSORS UND DIGITALER SENSOR**
METHOD OF CONTROLLING A DIGITAL SENSOR, AND CORRESPONDING DIGITAL SENSOR
PROCEDE DE COMMANDE D'UN DETECTEUR NUMERIQUE ET DETECTEUR NUMERIQUE CORRESPONDANT

(30) Priorität: 23.05.1996 DE 19620846; 19.07.1996 DE 29612565 U
(43) Veröffentlichungstag der Anmeldung: 10.03.1999
(73) Patentinhaber: IRO AB, 523 01 Ulricehamn (SE)
(72) Erfinder: ERIKSSON, Anders, S-183 36 Täby (SE)
(74) Vertreter: Grünecker, Kinkeldey, Stockmair & Schwanhäusser Anwaltssozietät
(86) Internationale Anmeldenummer: EP9702638
(87) Internationale Veröffentlichungsnummer: WO9744639

(56) Entgegenhaltungen:
- EP-A- 0 620 647
- GB-A- 2 276 246
- US-A- 5 119 998
- IBM TECHNICAL DISCLOSURE BULLETIN, Bd. 24, Nr. 10, März 1982, Seiten 5015-5016, XP002036879 "microcontrolled ribbon motion and splice detection system"

## Beschreibung

Die Erfindung betrifft ein Fadenspeicher- und -liefergerät gemäß dem Oberbegriff des Patentanspruchs 1.

in Fadenspeicher- und -liefergeräten gemäß EP-B-0 171 516 werden Fadensensoren zur berührungslosen Fadenabtastung eingesetzt, z.B. um Steuersignale für den Fadenaufwickelantrieb zu erzeugen, der im wesentlichen unabhängig vom Fadenverbrauch einen Fadenvorrat bestimmter Größe auf der Speichertrommel aufrechterhält. Der Fadensensor enthält einen Hallsensor oder Näherungssensor mit magnetoresistivem oder induktivem Sensorelement. Ein solcher Fadensensor läßt sich auch als Fadenbruchsensor verwenden. Der Faden bewegt einen in der Speichertrommel beweglich gelagerten Permanentmagneten, auf dessen Bewegung bzw. Abstand der Fadensensor anspricht. Beispielsweise digitale Hallsensoren sind kostengünstig und zuverlässig. Jedoch ist es nachteilig, daß der Ausgangssignalwechsel abhängig von der Bewegungsrichtung des Permanentmagneten oder eines Körpers aus magnetischen und/oder elektromagnetischen Fluß leitendem Material nicht bei dem selben Abstand vom Sensorelemet auftritt, was zu unpräzisen Aussagen bezüglich der Bewegung und/oder der An- bzw. Abwesenheit des Fadens führt. Da die Hysterese, z.B. digitaler Hallsensoren, innerhalb einer Baureihe streut und in ein- und demselben Fadenspeicher- und -liefergerät mehrere Fadensensoren vorgesehen sein können, mußte bisher ein ungenaues Steuerverhalten aus der Streuung der Fadensensoren in Kauf genommen werden, was unerwünscht zu einem zu großen oder zu kleinem Fadenvorrat und zu Störungen im Betrieb des Fadenspeicher- und -liefergeräts führen kann. Dies gilt sowohl für Hallelemente als Sensorelemente als auch für magnetoresistive oder induktive Sensorelemente.

Ein magnetisch aktivierter Näherungsschalter gemäß EP-A-0 620 647 überwacht die Position und Bewegung eines mit einem Betätigungskolben gekoppelten Magneten. Ein Steuerkreis umfaßt einen Hallsensor, der durch einen Sensor-Pulser periodisch mit ausreichender Spannung beaufschlagt wird, um eine Bewertung des Magnetfeldes vorzunehmen. Nach einer Bewertung wird die Spannung für den Hallsensor durch den Sensor-Pulser vermindert, um das Ausgangssignal des Hallsensors durch einen logischen Schaltkreis festzuhalten.

Ein aus GB-A-22 76 246 bekannter Halleffekt-Sensor weist ein Hallelement auf, dessen Ausgang mit einem Vergleicherglied verbunden ist, das mit einer Referenzspannung beaufschlagt wird, um das Ausgangssignal des Hallelementes zu digitalisieren.

Der Erfindung liegt die Aufgabe zugrunde, ein Fadenspeicher- und -liefergerät der eingangs genannten Art zu schaffen, bei dem sich aus dem Ansprechen des Fadensensorsabgeleitete Steuersignale exakt auf den Abstand des Permanentmagneten oder Körpers vom Sensorelement beziehen, unabängig davon, ob sich der Permanentmagnet oder Körper dem Sensorelement gerade nähert oder sich davon entfernt.

Die gestellte Aufgabe wird erfindungsgemäß mit den Merkmalen des Anspruchs 1 gelöst.

Die im Fadenspeicher-und -liefergerät für die Schaltzuverlässigkeit des Fadensensors gebrauchte Hysterese wird durch den Unterbrecher ihres Einflusses auf die Abstandsdetektion entledigt, da durch das der Abtastung des Ausgangssignals vorausgehende Ab- und Wiedereinschalten des Fadensensors vor dem Abtasten nur festgestellt wird, ob die Dichte des Magnetfeldes den Wert für den Operationspunkt erreicht hat oder nicht, und zwar unabhängig von der Bewegungsrichtung des das Sensorelement zum Ansprechen bringenden Körpers. Der Unterbrecher mit seiner Taktung ist für das zeitgerechte Ein- und Ausschalten des Fadensensors verantwortlich. Der Fadensensor kann nicht nur zu Überwachung der Größe des Fadenvorrats auf der Speichertrommel (Minimal- und/oder Maximalsensor, Referenzsensor) zur Steuerung des Aufwickelantriebs des Fadenspeicher- und -liefergeräts genutzt werden, sondern auch als Fadenbruchsensor, der bei Fadenbruch ein Abschaltsignal oder Warnsignal erzeugt.

Gemäß Anspruch 2 ist der Fadensensor des Fadenspeicher- und -liefergerätes baulich einfach. Im Regelfall wird einer Anordnung des Unterbrechers zwischen dem Sensorelement, z.B. einem Hallelement, und der Erdung der Vorzug gegeben.

Gemäß Anspruch 3 werden hohe Zuverlässigkeit, lange Standzeit und verlustarmes Arbeiten erreicht.

Gemäß Anspruch 4 lassen sich für den Fadensensor im Fadenspiecher-und -liefergerät präzise Schaltverhältnisse ohne störende Spannungsspitzen bzw. Beeinträchtigungen durch elektronischen Lärm erreichen.

Gemäß Anspruch 5 ergibt sich durch die Verwendung eines in das Fadenspeicher- und - liefergerät integrierten Mikroprozessors für mehrere Funktionen ein einfacher und kostengünstiger Aufbau.

Gemäß Anspruch 6 wird die für das Fadenspeicher- und -liefergerät wichtige Präzision bei der Abstandsdetektion mittels des Fadensensors erzielt.

Gemäß Anspruch 7 erzeugt das Schaltglied die für die Schaltzuverlässigkeit zweckmäßig Hysterese. Diese Hysterese wird aber ihres Einflusses auf die Abstandsdetektion entledigt, da durch das vorhergehende Ab- und Wiedereinschalten des Fadensensors der Lösepunkt des Schaltgliedes ignoriert und nur festgestellt wird, ob der Operationspunkt erreicht worden ist oder nicht. Der Ausgangssignalwechsel wird unabhängig von der relativen Bewegungsrichtung zwischen dem Permanentmagneten und dem Sensorelement jeweils für denselben Abstand detektiert.

Anhand der Zeichnung werden Ausführungsformen des Erfindungsgegenstandes erläutert. Es zeigen:
- Fig. 1: schematisch einen digitalen Sensor,
- Fig. 2: mehrere einander zugeordnete Zeitdiagramme, und
- Fig. 3: schematisch ein Fadenspeicher- und -liefergerät mit wenigstens einem Fadensensor.

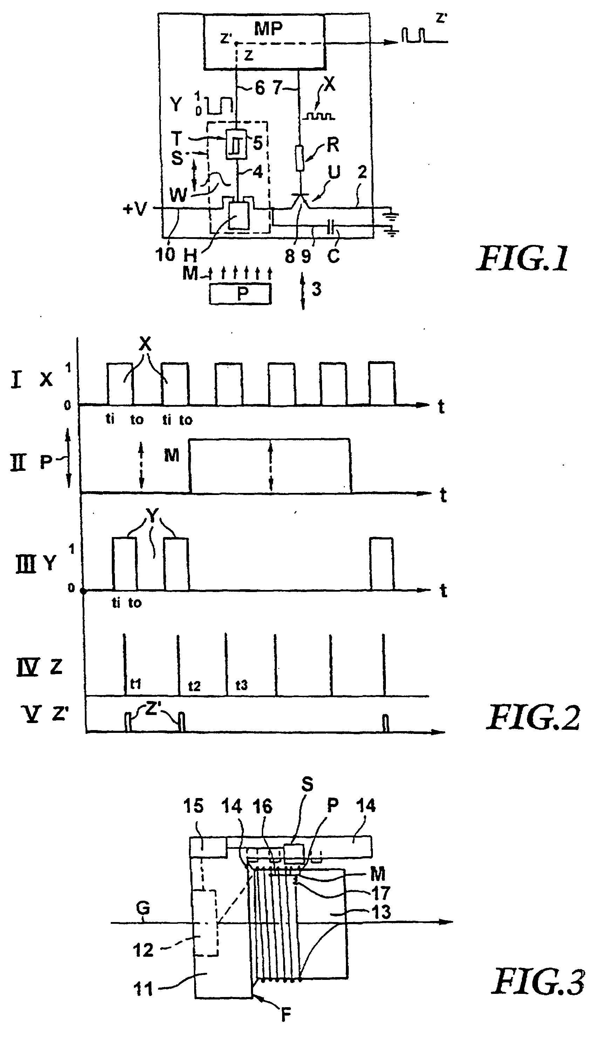

Ein digitaler Sensor S gemäß Fig. 1 (schematische Darstellung) enthält als hauptsächliche Komponenten ein Sensorelement H, z.B. ein Hallelement, ein integriertes, digitalisierendes, mit Hysterese arbeitendes Schaltglied T, einen Unterbrecher U sowie eine Auswerteschaltung und einen Taktgeber, die zweckmäßigerweise durch einen Mikroprozessor MP gebildet werden. Der Taktgeber für den getakteten Unterbrecher könnte jedoch auch von der Auswerteschaltung getrennt sein. Ferner könnte der Mikroprozessor MP außerhalb des Sensors S vorgesehen und mit diesem nur signalempfangend bzw. signalübertragend verbunden sein.

Das Sensorelement H, in diesem Fall ein Hallelement, ist mit einem Eingang über eine Leitung 10 mit einer Spannungsquelle + V, z.B. + 5V, verbunden, während sein anderer Eingang über eine Leitung 2 geerdet ist. Das Ansprechsignal des Sensorelementes H wird über eine Leitung 4 einem in den Sensor S integrierten Schaltglied T übermittelt, das ausgangsseitig über eine Leitung 6 mit einem Kontakt Z des die Auswerteschaltung bildenden Mikroprozessors MP verbunden ist. Das Schaltglied T operiert mit einer absichtlich vorgesehenen Hysterese und wird beispielsweise durch einen Schmitt-Trigger 5 gebildet, der aus analogen Ansprechsignalen W des Sensorelementes H digitale Ausgangssignale Y (1 oder 0) bildet. In der Leitung 2 ist der getaktete Unterbrecher U enthalten, zweckmäßigerweise ein NPN-Transistor 8, dessen Basis über eine Leitung 7 mit einem in der gezeigten Ausführungsform durch den Mikroprozessor MP gebildeten Taktgeber für Spannungsimpulse X verbunden ist. In der Leitung 7 kann ein Widerstand R enthalten sein. Parallel zum Unterbrecher U ist in einer geerdeten Leitung 9 ein Kondensator C vorgesehen. Der Anschlußpunkt der Leitung 9 liegt zwischen dem Unterbrecher U und dem Eingang des Sensorelements.

Das Sensorelement H wird mit einem Magnetfeld M veränderbarer Dichte beaufschlagt, beispielsweise mittels eines Permanentmagneten P, der sich in Richtung eines Doppelpfeiles 3 relativ zum Sensorelement H bewegt. Das Sensorelement H könnte auch ein magnetoresistives Sensorelement sein. Brauchbar ist ferner ein induktives Sensorelement, das auf die Nähe eines zumindest eisenhaltigen oder metallischen Körpers P anspricht.

Das Sensorelement H gibt (Leitung 4) analoge Ansprechsignale W ab, und zwar in Abhängigkeit von der Dichte des Magnetfeldes M. Das in den Sensor S integrierte Schaltglied T, d.h. der Schmitt-Trigger 5, erzeugt aus den Ansprechsignalen W digitale Ausgangssignale Y (1 oder 0), die bei Z im Mikroprozessor MP abgestastet werden, und aus denen der Mikroprozessor MP Steuersignale Z' ableitet.

Das Schaltglied T schaltet am Operationspunkt bei einem vorbestimmten Gauss-Wert des Magnetfeldes M (Annähern des Permanentmagneten P an das Sensorelement) das Ausgangssignal Y auf einen dem Wert 0 entsprechenden Spannungspegel. Bei Verringerung der Dichte des Magnetfeldes M (Entfernen des Permanentmagneten) schaltet das Schaltglied T am Lösepunkt das Ausgangssignal Y auf einen hohen Signalpegel 1, sobald ein aufgrund der Hysterese niedrigerer Gauss-Wert als beim Auslösepunkt erreicht ist. Dies bedeutet, daß der Ausgangssignalwechsel von 0 auf 1 bei einem anderen Abstand zwischen dem Sensorelement H und dem Permanentmagneten P auftritt als der Ausgangssignalwechsel von 1 auf 0. Durch den getakteten Unterbrecher U wird jedoch für die Abtastung des Ausgangssignals Y durch den Mikroprozessor MP der eine der beiden Ausgangssignalwechsel, z.B. beim Lösepunkt, der Abtastung dadurch entzogen, daß der Unterbrecher U jeweils vor einer Abtastung des Ausgangssignals Y das Sensorelement H abschaltet und vor der Abtastung wieder einschaltet. Durch das Abschalten kann der Mikroprozessor den einen Ausgangssignalwechsel, z.B. von 1 auf 0, nicht mehr abtasten, sondern nur, ob der eine Ausgangssignalwechsel, z.B. von 0 auf 1, stattgefunden hat oder nicht In weiterer Folge bedeutet dies, daß der Mikroprozessor unabhängig von der jeweiligen Bewegungsrichtung des Permanentmagneten P (Doppelpfeil 3) nur feststellt, ob der eine Ausgangssignalwechsel, z.B. von 0 auf 1, bereits stattgefunden hat oder nicht.

Fig. 2 verdeutlicht im Diagramm I die Spannungsimpulse X entlang der Zeitachse t, mit denen der Mikroprozessor MP den Unterbrecher U zum Ein- und Ausschalten des Sensorelements H betätigt. Jeweils zu einem Zeitpunkt ti wird das Sensorelement H eingeschaltet, und zwar bis zum darauffolgenden Zeitpunkt to, an dem wieder abgeschaltet wird. Zweckmäßigerweise sind die Einschalt- und Ausschaltzeiten gleich lang (Frequenz z. B. 300 Hz).

Das darunterliegende Diagramm II verdeutlicht die Veränderung des Magnetfeldes M über der Zeitachse t bzw. die Abstandsänderung des Permanentmagneten P. Das Diagramm III repräsentiert die Ausgangssignale Y über der Zeitachse t bei Ansprechen des Sensorelements H. Solange das Magnetfeld M schwach ist (Permanentmagnet P entfernt vom Sensorelement H) liegt über jede Einschaltzeit (zwischen ti und to) das Ausgangssignal Y mit dem Wert 1 an. In den Abschaltzeiten (zwischen to und ti) liegt das Ausgangssignal Y mit dem Wert 0 an. Hat sich der Permanentmagnet P dem Sensorelement H ausreichend weit genähert, dann bleibt das Ausgangssignal Y auf dem Wert 0. Hat sich der Permanentmagnet P ausreichend weit vom Sensorelement H entfernt, dann liegt in den Einschaltzeiten das Ausgangssignal Y mit dem hohen Wert 1 an. Im Diagramm IV ist gezeigt, wie der Mikroprozessor MP zu den Zeitpunkten t1, t2, t3 das Ausgangssignal Y abtastet, wobei die Zeitpunkte t1, t2, t3 jeweils innerhalb einer Einschaltzeit (ti bis to) liegen, zweckmäßigerweise jeweils in etwa in der zeitlichen Mitte der Einschattzeit. Im Diagramm V ist schießlich angedeutet, wie der Mikroprozessor MP aus dem abgetasteten Ausgangssignal zu den Zeitpunkten t1, t2, t3 ein Steuersignal Z' erzeugt, hingegen über die Zeitdauer, in der der Permanentmagnet P dem Sensorelement H nahe ist, keine Steuersignale Z' abgibt.

Da das im Diagramm III äußerst rechte Ausgangssignal Y nur dann abgetastet wird, wenn das Sensorelement H zuvor abgeschaltet und wieder eingeschaltet worden ist, bleibt außer Betracht, daß der Ausgangssignalwechsel (z.B. von 1 auf 0) bei einem anderen Abstand zwischen Permanentmagnet P und dem Sensorelement H stattgefunden hat, als der vorausgehende Ausgangssignalwechsel (z.B. von 0 auf 1).

Der digitale Sensor gemäß Fig. 1 ist in Fig. 3 in einem Fadenspeicher- und -liefergerät F als Fadensensor vorgesehen. In einem Gehäuse 11 des Fadenspeicher- und - liefergeräts F ist ein Aufwickelantrieb 12 (ein Elektromotor) angeordnet, der ein Aufwickelelement 14 antreibt, mit dem auf einer stationären Speichertrommel 13 ein aus Windungen bestehender Fadenvorrat gebildet wird, aus dem eine nicht dargestellte Textilmaschine, z.B. eine Webmaschine, bedarfsabhängig Faden verbraucht. Der Aufwickelantrieb 12 hat die Aufgabe, unabhängig vom Verbrauch durch die Textilmaschine stets einen ausreichend großen Vorrat des Fadens G aufrechtzuerhalten, d.h., sicherzustellen, daß der Vorrat nicht zu groß oder zu klein wird. In der Speichertrommel 13 ist auf einem durch eine Feder 17 nach außen beaufschlagten Fühler 16, z.B. der Permanentmagnet P oder ein Körper aus magnetischen und/oder elektromagnetischen Fluß leitendem Material angeordnet. Jenachdem, ob sich Faden im Bereich des Permanentmagneten P, oder ein Körper befindet, oder nicht, nimmt der Permanentmagnet P eine in die Speichertrommel 13 zurückgezogene Position oder eine über die Speichertrommel vorstehende Position ein. Unter Berücksichtigung nur eines einzigen Abstandswertes zwischen dem Permanentmagneten P und dem Sensorelement H, z.B. einem Hallelement, des Fadensensors S werden Steuersignale an eine Steuervorrichtung 15 für den Aufwickelantrieb 12 übermittelt, um diesen zur Ergänzung des Fadenvorrats anzutreiben oder zu beschleunigen bzw. zum Verhindern einer Überschreitung der gewünschten Größe des Fadenvorrates anzuhalten oder zu verzögern. Der Fadensensors S entspricht dem Sensor S der Fig. 1 und ist in der Lage, Steuersignale in Abhängigkeit davon abzugeben, ob der Abstand des Permanentmagneten P einen exakt vorbestimmten Wert hat, oder nicht, und zwar unabhängig davon, ob sich der Permanentmagnet P dem Sensorelement nähert oder sich von diesem entfernt.

Strichliert ist in Fig. 3 angedeutet, daß nicht nur ein einziger Fadensensor S vorgesehen sein kann, sondern gegebenenfalls weitere gleichartige Fadensensoren, auch ein Fadenbruchsensor.

## Patentansprüche

1. Fadenspeicher- und -liefergerät (F) mit stationärer Speichertrommel (13) und wenigstens einem im Abstand von der Speichertrommel (13) angeordneten Fadensensor (S), der ein Sensorelement (H) wie ein Hallelement aufweist und auf das Magnetfeld (M) eines in der Speichertrommel (13) beweglich angeordneten Körpers (P) aus magnetischen oder/und elektromagnetischem Fluß leitendem Material ausgerichtet ist, der durch einen auf die Speichertrommel (13) in Windungen aufgewickelten Faden (G) in Abhängigkeit von der Ab- und Anwesenheit bzw. einer Bewegung des Fadens (E) entlang der Speichertrommel (13) zwischen dem Sensorelement (H) nahen und dem Sensorelement (H) fernen Positionen bewegbar ist, wobei Ausgangssignale (Y) des Fadensensors (S) zum Ableiten von zumindest Steuersignalen (Z') für einen Fadenaufwickelantrieb (12) periodisch abtastbar sind, **dadurch gekennzeichnet, daß** im Fadensensor (S) ein getakteter Unterbrecher (U) zum abwechselnden Ein- und Ausschalten des Fadensensors (S) vorgesehen und in seiner Taktfrequenz auf die Abtastfrequenz derart abgestimmt ist, daß das jeweilige Ausgangssignai (Y) ausschließlich bei erst vor der Abtastung aus- und wieder eingeschaltetem Fadensensor (S) abtastbar ist.

2. Fadenspeicher- und -liefergerät nach Anspruch 1, **dadurch gekennzeichnet, daß** der Unterbrecher (U) zwischen dem Sensorelement (H), vorzugsweise einem Hallelement eines Hallsensors oder einem magnetoresistiven oder induktiven Sensorelement, und der Erdung oder zwischen dem Sensorelement (H) und einer Spannungsquelle (V) angeordnet und mit einem Taktgeber (MP) verbunden ist.

3. Fadenspeicher- und -liefergerät nach Anspruch 2, **dadurch gekennzeichnet, daß** der Unterbrecher (U) ein Schalttransistor (8), vorzugsweise ein NPN-Transistor, ist, an dessen Basis als Taktgeber (NP) ein Pulsgeber für Spannungsimpulse (X) angeschlossen ist.

4. Fadenspeicher- und -liefergerät nach den Ansprüchen 2 und 3, **dadurch gekennzeichnet, daß** parallel zum zwischen dem Sensorelement (H) und der Erdung vorgesehenen Unterbrecher (U) ein geerdeter Kondensator (C) vorgesehen ist, und daß zwischen dem Unterbrecher (U) und dem Pulsgeber (MP) ein Widerstand (R) angeordnet ist.

5. Fadenspeicher- und -liefergerät nach wenigstens einem der Ansprüche 3 oder 4, **dadurch gekennzeichnet, daß** der Pulsgeber (MP) in einem Mikroprozessor vorgesehen ist, mit dem auch das Ausgangssignal (Y) abtastbar ist.

6. Fadenspeicher- und -liefergerät nach wenigstens einem der Ansprüche 1 bis 5, **dadurch gekennzeichnet, daß** bei einer Versorgungsspannung von ca. +MV ein ca. 1 kΩ-Widerstand (R) und ein 100 Nf-Kondensator (C) vorgesehen sind, und daß die Taktfrequenz auf ca. 300 Hz eingestellt ist.

7. Fadenspeicher- und -liefergerät nach wenigstens einem der vorhergehenden Ansprüche, **dadurch gekennzeichnet, daß** der Fadensensor ein ein Ansprechsignal (W) des Sensorelements (H) in unterschiedliche Ausgangssignale (Y) digitalisierendes Schaltglied (T) mit Hysterese, wie einen Schmitt-Trigger, aufweist, der, zum Abtasten der Ausgangssignale (Y) zu vorbestimmten Zeitpunkten (t1, t2, t3), an den Mikroprozessor angeschlossen ist.

## Claims

1. Yam feeder (F) comprising a stationary storage drum (13) and at least one yarn sensor (S) arranged with distance from said storage drum (13), said yam sensor (S) having a sensor element (H) like a Hall element and being directed to the magnetic filed (M) of a body (P) of magnetic and/or electromagnetic flux conducting material movably provided in said storage drum (13), which body (P) is movable between positions close to the sensor element (H) and remote from the sensor element (H), depending on the presence and absence on or a movement of yarn (G) along said storage drum (13), which yam is wound onto the storage drum (13) in windings, and output signals (Y) of said yarn sensor (S) are periodically detected to derive at least control signals (Z') for a yam winding-on drive (12), **characterised in that** a cyclically clocked interrupter (U) is provided in said yam sensor (S) to alternatingly switch on and off the yarn sensor (S), said interrupter being tuned with its clock frequency to the detection frequency such that the respective output signal (Y) exclusively is detected when the yam sensor (S) has been switched off and again switched on prior to the detection.

2. Yarn feeder as in claim 1, **characterised in that** the interrupter (U) is provided between the sensor element (H), preferably a Hall element of a Hall sensor or a magnetic resistive or inductive sensor element, and the ground or between the sensor element (H) and a voltage source (+V), and is connected with a cycling clock (MP).

3. Yarn feeder as in claim 2, **characterised in that** said interrupter (U) is a switching transistor (8), preferably a NPN transistor, to the basis of which a cycling clock (MP) a pulse generator for voltage pulses (X) is connected.

4. Yarn feeder as in claims 2 and 3, **characterised in that** a capacitor (C) connected to ground is provided parallel to said interrupter (U) which is arranged between the sensor element (H) and a the ground, and that a resistor (R) is provided between the interrupter (U) and the cycling clock (MP).

5. Yarn feeder as in at least one of claims 3 or 4, in that said cycling clock (MP) is provided in a microprocessor also serving to detect the output signal (Y).

6. Yam feeder as in at least one of claims 1 to 5, **characterised in that** for a supply voltage of about +5V, a resistor (R) of 1kΩ and a capacitor (C) of 100 nF are provided, and that the cyclic clock frequency is adjusted to about 300 Hz.

7. Yarn feeder as in at least one of the preceding claims, **characterised in that** said yarn sensor (S) comprises a switching member (T) having hysteresis, like a Schmitt Trigger, for digitising a response signal (W) of the sensor element (H) into differing output signals (Y), which switching member (T) is connected to said microprocessor in order to detect or sample said output signals (Y) at predetermined points in time (t1, t2, t3).

## Revendications

1. Dispositif de stockage et de fourniture de fil (F) comprenant un tambour de stockage (13) fixe et au moins un capteur de fil (S), qui est disposé à une distance donnée du tambour de stockage (13) et qui est muni d'un élément de capteur (H), tel qu'un élément à effet Hall, et est dirigé vers le champ magnétique (M) d'un corps (P), réalisé dans un matériau magnétique et/ou conducteur de flux électromagnétique et logé de manière mobile dans le tambour de stockage (13), lequel, au moyen d'un fil (G) enroulé en spires sur le tambour de stockage (13), peut se déplacer, en fonction de la présence ou de l'absence du fil (E) ou d'un mouvement du fil (E), le long du tambour de stockage (13) entre une position proche de l'élément de capteur (H) et une position éloignée de l'élément de capteur (H), des signaux de sortie (Y) du capteur de fil (S), destinés à dériver au moins des signaux de commande (Z') pour un dispositif d'enroulement du fil (12), pouvant être analysés périodiquement, **caractérisé en ce qu'**il est prévu dans le capteur de fil (S) un interrupteur (U) cadencé, qui est destiné à activer et désactiver le capteur de fil (S) et dont la cadence est synchronisée avec la fréquence d'analyse, de telle sorte que chaque signal de sortie (Y) peut être analysé exclusivement lorsque le capteur de fil (S) a été désactivé et à nouveau activé juste avant le processus d'analyse.

2. Dispositif de stockage et de fourniture de fil selon la revendication 1, **caractérisé en ce que** l'interrupteur (U) est disposé entre l'élément de capteur (H), de préférence un élément d'un capteur à effet Hall ou un élément de capteur magnétorésistif ou inductif, et la terre ou entre l'élément de capteur (H) et une source de tension (V) et est relié à un synchroniseur (MP).

3. Dispositif de stockage et de fourniture de fil selon la revendication 2, **caractérisé en ce que** l'interrupteur (U) est un transistor de commutation (8), de préférence un transistor N-P-N, à la base duquel est raccordé un générateur d'impulsions sous forme de synchroniseur (NP) pour les impulsions de tension (X)

4. Dispositif de stockage et de fourniture de fil selon les revendications 2 et 3, **caractérisé en ce que**, parallèlement à l'interrupteur (U), prévu entre l'élément de capteur (H) et la terre, il est prévu un condenseur (C) relié à la terre et **en ce qu'**une résistance (R) est montée entre l'interrupteur (U) et le générateur d'impulsions (MP).

5. Dispositif de stockage et de fourniture de fil selon au moins une des revendications 3 ou 4, **caractérisé en ce que** le générateur d'impulsions (MP) est prévu dans un microprocesseur, par lequel il est également possible d'analyser le signal de sortie (Y).

6. Dispositif de stockage et de fourniture de fil selon au moins l'une des revendications 1 à 6, **caractérisé en ce que**, en présence d'une tension d'alimentation de +MV environ, il est prévu une résistance (R) de 1 kΩ environ et un condenseur (C) de 100 Nf, et **en ce que** la cadence est régulée à 300 Hz environ.

7. Dispositif de stockage et de fourniture de fil selon au moins l'une des revendications précédentes, **caractérisé en ce que** le capteur de fil comporte un circuit logique (T) avec hystérésis, tel qu'un déclencheur de Schmitt, qui numérise un signal de déclenchement (W) de l'élément de capteur (H) en différents signaux de sortie (Y) et qui est relié à un microprocesseur pour analyser les signaux de sortie (Y) à des moments (t1, t2, t3) prédéterminés.
